Europäisches Patentamt

(19) European Patent Office

Office européen des brevets

(11) Publication number: **0 137 589**
**A1**

## (12) EUROPEAN PATENT APPLICATION

(21) Application number: **84304563.4**

(22) Date of filing: **04.07.84**

(51) Int. Cl.⁴: **H 05 K 7/02**

(30) Priority: **26.08.83 US 526718**

(43) Date of publication of application:
**17.04.85 Bulletin 85/16**

(84) Designated Contracting States:
**CH DE FR GB IT LI NL**

(71) Applicant: **MOLEX INCORPORATED**
**2222 Wellington Court**
**Lisle Illinois 60532(US)**

(72) Inventor: **Pierce, Richard L.**
**538 Longmeadow Circle**
**St. Charles Illinois 60174(US)**

(72) Inventor: **Wilson, Bill B.**
**16 W 525 Lake Drive**
**Clarendon Hills Illinois 60514(US)**

(72) Inventor: **Colleran, Stephen A.**
**12931 Elaine Drive**
**Plainfield Illinois 60544(US)**

(74) Representative: **Slight, Geoffrey Charles et al,**
**Graham Watt & Co. Riverhead**
**Sevenoaks Kent TN13 2BN(GB)**

(54) **Integrated circuit connector.**

(57) An electrical connector (30) for establishing electrical connections between an electronic circuitry package (20) and an edge connector socket (12) comprises a body member (31) having an integrally formed plug portion (40, 48) extending therefrom and is fitted with a plurality of terminals (32). Each terminal includes a first end (33) having a contact portion (36) for selective engagement with a respective lead (22) of the circuitry package (20) and a second end (37) adapted to simulate a typical double-sided edge contact arrangement of a printed circuit board. A cover (18) is provided environmentally sealing the circuitry package (20) in mounted disposition on the connector, thereby forming a module having the capability of being plugged directly into a standard edge connector socket (12).

FIG.2

## "INTEGRATED CIRCUIT CONNECTOR"

This invention relates to an electrical connector for connecting an electronic circuit package to an edge connector e.g. a typical printed circuit board edge connector.

With ongoing developments in semi-conductor technology, ever-increasing miniaturization and economies are possible in the manufacture of electronically controlled equipment and products. Logic circuitry capable of performing diverse and numerous control functions is now available in relatively small circuitry packages. Such packages typically comprise an encapsulated semi-conductor chip having metallic leads for interconnection of the package to other electronic apparatus. In common practice, the circuitry packages are mounted on insulative substrates such as printed circuit boards, for example, with their leads soldered to electrically conductive paths defined on the substrates.

It has been found desirable to mount circuitry packages using a carrier system wherein the package is inserted into a support member with its leads configured so as to be engaged by spring terminals which have been fitted into the support member and then soldered or forced into the boards. A carrier system offers the advantage of ease of circuit package replacement. However, in a printed circuit board system, it contributes added cost to initial manufacture of the associated equipment or product and, in some applications, is deemed cost prohibitive.

A modular approach to the arrangement of complex circuitry elements is particularly suitable for use in video game or small computer apparatus, for example, wherein an electronic circuit package, housed in a cartridge, is selectively insertable into a processing unit. With such a system, a variety of programs may be used with the same processor. An example of a typical cartridge system is disclosed in Asher, et al., U.S. Patent No. 4,149,027 issued April, 10 1979. The cartridge, basically, comprises microcircuitry mounted on a printed circuit board with electrical contact pads defined along an edge of the board. Electrical coupling of the cartridge is facilitated through the use of an edge connector mounted within the processor unit.

With recent advancements in semi-conductor technology, the circuitry requirements of many logic or game programs can be embodied in a single electronic package and, in such a case, the advantages of using a printed circuit board to interconnect a plurality of circuit devices are no longer extant. Accordingly, it would be desirable to eliminate the need for reliance on printed circuit boards in such applications, thereby reducing associated material and assembly costs. Printed circuit boards also have significant limitations in terms of their cycle life when used with an edge connector. These limitations reside in the inability to adequately control the thickness and quality of the  contact pads of the board such that they can withstand the effects of frictional wear during repeated mating and unmating with the terminals of the edge connector. Moreover, many prior module or cartridge systems do not permit manual replacement of the electronic circuitry package without rigorous disassembly and reassembly methods. Thus when the circuit package fails, a least costly alternative for replacement typically involves discarding the entire cartridge or module with attendant sacrifice of otherwise functional components.

An object of the present invention is to provide an improved means for connecting a circuitry package to an edge connector without the need for mounting the package on a printed circuit board.

The present invention provides an electrical connector for establishing electrical connections between an electronic package and a circuit member, the electronic package having a plurality of leads associated therewith, said connector including a carrier for mounting the electronic package and a socket having means for forming electrical connections between the electronic package and the circuit member, said carrier having a body member with a plurality of terminals supported thereon, said terminals having first and second end poritions, the first end portions being adapted for selective mating and unmating with the leads of the electronic package and the second end portions being adapted for selective mating and unmating with the electrical connection means of the socket.

One way of carrying out the invention will now be described by way of example and not by way of limitation with reference to drawings which illustrate an electrical circuitry package assembly including one specific embodiment of an electrical connector carrier in accordance with the present invention.

In the drawings:

Fig. 1 is a perspective view of the assembly;

Fig. 2 is an exploded perspective view, partially in section, of the assembly of Fig. 1;

Fig. 3 is a perspective view of a terminal used with the connector of the present invention;

Fig. 4 is a side cross-sectional view taken generally along the line 4-4 of Fig. 2 and illustrating a step in the assembly of the instant connector; and

Fig. 5 is a partial cross-sectional view taken generally on line 5-5 of Fig. 4.

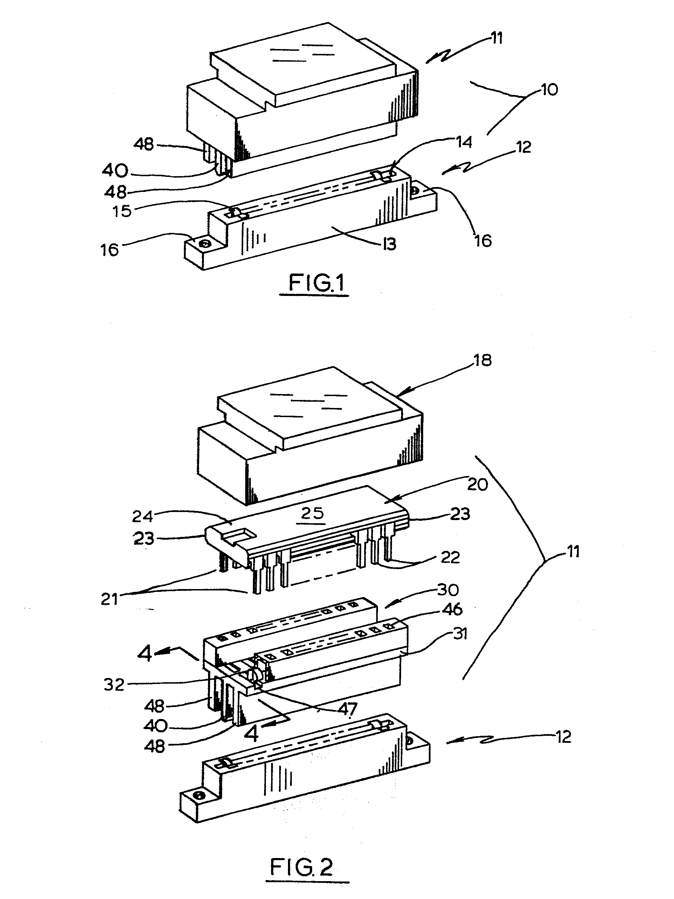

Referring now to the drawings, in Fig. 1, the circuitry package connector assembly is designated generally by the reference numeral 10. The assembly 10 comprises a circuitry package module and an edge connector socket, designated generally by the reference numerals 11 and 12, respectively. The edge connector 12 comprises a dielectric housing 13 having a central cavity 14 into which are fitted a plurality of electrically-conductive stamped and formed terminals 15. The housing 13 may be adapted with suitable mounting means 16 for mechanical connection to another electronic assembly (not shown).

The edge connector socket 12 is of a type which is capable of receiving and forming electrical connections with a typical double-sided printed circuit board having a plurality of contact pads along one of its edges. In accordance with the present invention, the module 11 is adapted to simulate the configuration of a typical circuit board edge through the provision of a plug-like structure or portion, designated generally by the reference numeral 17. The edge connector 12 is able to receive the plug portion 17 of the module 11 into the cavity 14.

Turning now to Fig. 2, the module 11 is shown in exploded perspective revealing its component parts which include a cover 18, an electronic circuitry package 20 and a connector 30. The circuitry package 20 is of a dual-in-line type, having rows 21 of leads 22 depending from edges 23 of an encapsulated semi-conductor device 24. The leads 22 of such circuitry packages 20 are readily deformable such that they may be bent orthogonally with respect to a major surface 25 of the semi-conductor device 24 with predetermined lateral separation of the rows 21.

The connector 30 generally includes a body member 31 which is molded from suitable dielectric material such that a plurality of terminals 32 may be supported, thereon, in insulated relationship one to another. The terminals 32 of the connector 30 are spatially arranged on body member 31 so that each lead 22 of the circuitry package 20 may contact a respective terminal 32 of the connector 30.

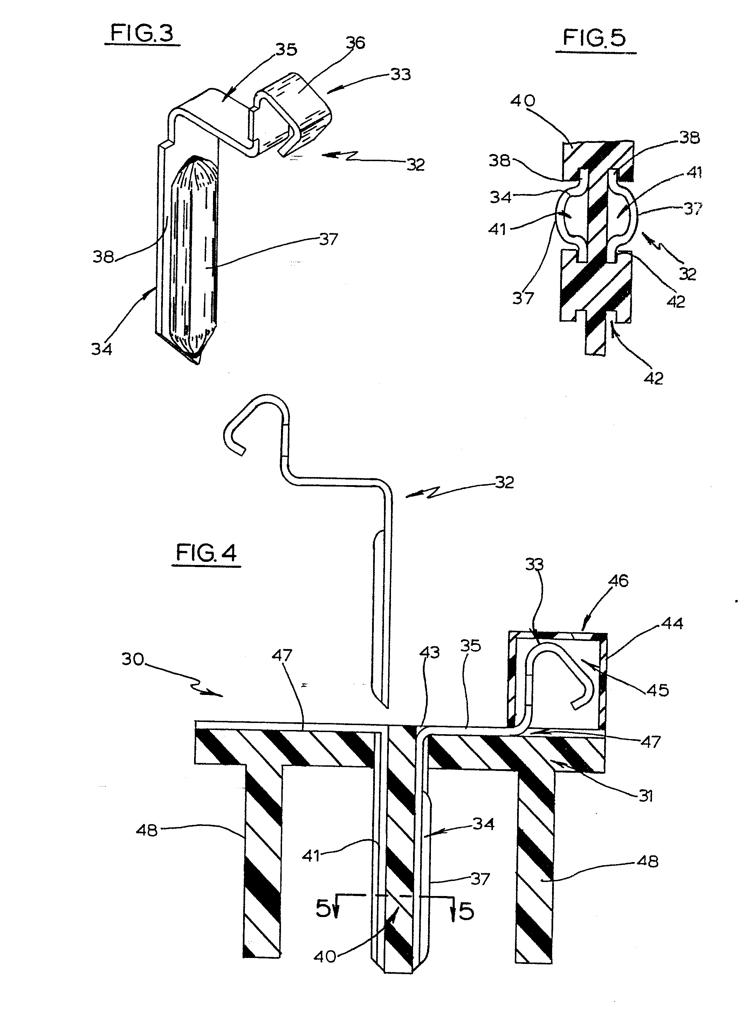

With reference to Fig. 3, the terminal 32 is shown in enlarged perspective and is seen to include first and second end portions 33 and 34, respectively, connected by an intermediate portion 35. In order to provide for selective interengagement with the leads 22 of the circuitry package 20, the first portion 33 of the terminal 32 comprises a formed spring arm 36 which is reversely bent to project in a direction which is generally co-extensive with the direction of intended lead 22 insertion. The second end portion 34 of the terminal 32 is generally elongated and is formed with a slightly curved contact surface 37 flanked by flanges 38 which run the length of the terminal end portion 34.

As seen in Figs. 4 and 5, the body member 31 of the connector 30 has a terminal support portion, designated generally by the reference numeral 40 extending substantially orthogonally therefrom. The terminal support portion 40 is a relatively rigid structure adapted with a plurality of channels, designated generally by the reference numeral 41. The channels 41 serve to slidingly receive the second terminal end portions 34 and retain the terminals 32 in fixed disposition with respect to the connector 30. To this end, terminal support means 40 is adapted with recesses 42 communicating with the interior of the channels 41. Each recess 42 is suitable dimensioned such that it may cooperate with a respective flange 38 of a terminal 32 in closely fitting slidable engagement. Aligned with each channel 41 and extending through the body member 31 are apertures 43 which permit terminal end portions 34 to be received by the channels 41 during assembly.

For proper support of the electronic circuitry package 20, the connector 30 includes a pair of generally elongated terminal housings, designated generally by the reference numeral 44. The housings 44 are formed with central cavities 45 of suitable dimension such that they completely enclose the first end portions 33 of terminals 32. The housings 44 are further adapted with apertures 46 permitting access to the spring arms 45 by respective leads 22 of the circuit package 20. Securing of the housings 44 to the body member 31 may be accomplished by appropriate chemical bonding techniques or by ultrasonic welding. The terminals 32 are retained on the body member 31 by their entrapment within respective grooves 47 formed therein. Once the connector 30 and circuitry package 20 have been assembled, the cover 18 may be similarly secured to the body member 31. This provides environmental sealing of the structure within.

In certain applications, it might be desirable to adapt the connector 30 with means for stabilizing the connector in its mated disposition with respect to the edge connector 12. Accordingly, the body member 31 is preferably adapted with integrally formed walls 48 depending therefrom. Although in the illustrative embodiment only two walls 48 have been shown, the body member 31 may be molded in other well-known configurations. For example, if desired, the walls 48 may be formed as a complete four-sided enclosure to provide a cavity within which the edge connector housing 13 is completely nestable.

Additionally, depending upon the circuitry requirements of the assembly 10, it might be desirable to provide a polarizing arrangement which assures that the module 11 and edge connector socket 12 are matable in only one orientation with respect to each other. Although not shown, in a manner well-known in the art, the terminal support means 40 or walls 48 of the carrier body 31 may be adapted with suitably formed ribs, for example, to be received by complementary grooves formed in the housing 13 of the edge connector socket 12 thereby polarizing the module 10 and edge connector 11 with respect to one another.

It can be appreciated from the foregoing description that the connector 30 of the instant invention eliminates the need for reliance on a printed circuit board in electrically coupling a circuit package to a standard printed circuit board edge connector. In addition, because the terminal 32 functions as, essentially, a replacement for the edge of a typical printed circuit board, significantly greater control of the cycle life of the described circuitry package module is possible by virtue of the use of known plating techniques applicable to metallic terminal design. Moreover, should the circuitry package fail during use, it may be conveniently and inexpensively replaced because the terminal 32 performs the dual function of both simulating a circuit board contact and providing selective contact for the leads of the circuitry package.

Claims:

1. An electrical connector (30) for electrically connecting an electronic circuitry package (20) having rows (21) of in-line leads (22) depending therefrom to an edge connector socket (12), characterised by

a rigid dielectric carrier for supporting said circuitry package, said carrier including a body member (31) with integrally formed terminal support means (40) extending therefrom; and

a plurality of stamped and formed terminals (32) mounted in said carrier each terminal having a first end portion (33) for selective mating and unmating with the leads (22) of the circuitry package, an intermediate portion (35) extending across the body member of the carrier, and a second end portion (34) cooperating with the terminal support means of the carrier to define a multi-contact plug portion,

whereby the plug portion is selectively insertable into and mateable with the edge connector socket.

2. The connector of claim 1 wherein said terminal support means (40) extends substantially orthogonally from said body member (31).

3. The connector of claim 2 further including wall means (48) extending from said body member (31) in the direction of said terminal support means (40) for aligning the carrier with respect to said socket.

4. The connector of claim 2 or 3, wherein each of said second terminal end portions includes a generally elongated contact surface (37) with lengthwise flanges (38) along the eges thereof and said terminal support means includes channels (41) for slidingly receiving the flanges and retaining said terminals within said channels.

5. The connector of any preceding claim wherein the first terminal end portions (33) include a spring contact arm (36) for providing a biased electrical connection between the terminals and the leads (22) of the electronic package.

6. The connector of any preceding claim, including a cover (18) engageable with the carrier to environmentally seal an electronic circuitry package (20) mounted therein.

FIG.1

FIG.2

0137589

FIG.3

FIG.5

FIG.4

0137589

## European Patent Office

**EUROPEAN SEARCH REPORT**

Application number

EP 84 30 4363

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 389 697 (BELL et al.) <br> * Column 1, line 49 - column 2, line 24; figures 1, 2 * | 1-3 | H 05 K 7/02 |
| | --- | | |
| A,D | US-A-4 149 027 (ASHER et al.) <br><br> * Column 4, line 17 - column 5, line 42; figures 1-9C * | | |
| | ----- | | |

|  |  |
|---|---|
| | **TECHNICAL FIELDS SEARCHED (Int. Cl.4)** |
| | H 05 K 7/02 |

The present search report has been drawn up for all claims

| Place of search | Date of completion of the search | | Examiner |
|---|---|---|---|
| BERLIN | 20-11-1984 | HAHN G | |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO Form 1503. 03.82